## Europäisches Patentamt

## European Patent Office

## Office européen des brevets

(11) Veröffentlichungsnummer: **0 186 140 B1**

(12) **EUROPÄISCHE PATENTSCHRIFT**

(45) Veröffentlichungstag der Patentschrift:
27.09.89

(51) Int. Cl.⁴: **H01L 29/08**, H01L 29/743, H01L 29/72

(21) Anmeldenummer: 85116253.7

(22) Anmeldetag: 19.12.85

(54) Halbleiter-Leistungsschalter.

(30) Priorität: 27.12.84 DE 3447513

(43) Veröffentlichungstag der Anmeldung:
02.07.86 Patentblatt 86/27

(45) Bekanntmachung des Hinweises auf die Patenterteilung:
27.09.89 Patentblatt 89/39

(84) Benannte Vertragsstaaten:
CH DE FR GB IT LI

(73) Patentinhaber: Siemens Aktiengesellschaft,
Wittelsbacherplatz 2, D-8000 München 2(DE)

(72) Erfinder: Strack, Helmut, Dr., Speyerer Strasse 6,
D-8000 München 40(DE)
Erfinder: Herberg, Helmut, Dr., Bruderhofstrasse 30a,
D-8000 München 70(DE)

(56) Entgegenhaltungen:
EP-A- 0 110 777
EP-A- 0 126 611
EP-A- 0 128 268
FR-A- 2 424 631
GB-A- 2 077 491

ELECTRONIC COMPONENTS AND APPLICATIONS,
Band 4, Nr. 1, November 1981, Seiten 2-10, Eindhoven,
NL; F. BURGUM et al.: "Fast turn-off asymmetric silicon
controlled rectifiers"

## Beschreibung

Der Betrieb eines Halbleiter-Leistungsschalters wie z. B. eines Schalttransistors oder eines GTO-Thyristors ist durch zwei Zustände gekennzeichnet. Im stromführenden Zustand liegt am Leistungsschalter eine Restspannung an, die im allgemeinen der Sättigungsspannung entspricht und in der Größenordnung 1 V oder darunter liegt. Im gesperrten Zustand liegt am Halbleiter-Leistungsschalter die gesamte Betriebsspannung an. Sowohl beim Einschalten als auch beim Ausschalten durchfährt der Leistungsschalter Bereiche im Kennlinienfeld, die als "sichere Arbeitsbereiche" (SOA = Safe Operating Area) bezeichnet werden. Diese Bereiche geben an, welche Strom-Spannungswerte der Leistungsschalter abhängig von der Betriebstemperatur als Parameter nicht überschreiten darf. Die "sicheren Arbeitsbereiche" sind sowohl für den Einschaltvorgang als auch für den Abschaltvorgang definiert. Dabei ist der sichere Arbeitsbereich für den Abschaltvorgang der wichtigere, da der Abschaltvorgang kritischer ist und das Abschaltverhalten eines Halbleiter-Leistungsschalters wesentlich die Leistungsfähigkeit des Gerätes bestimmt, in das dieser eingebaut ist.

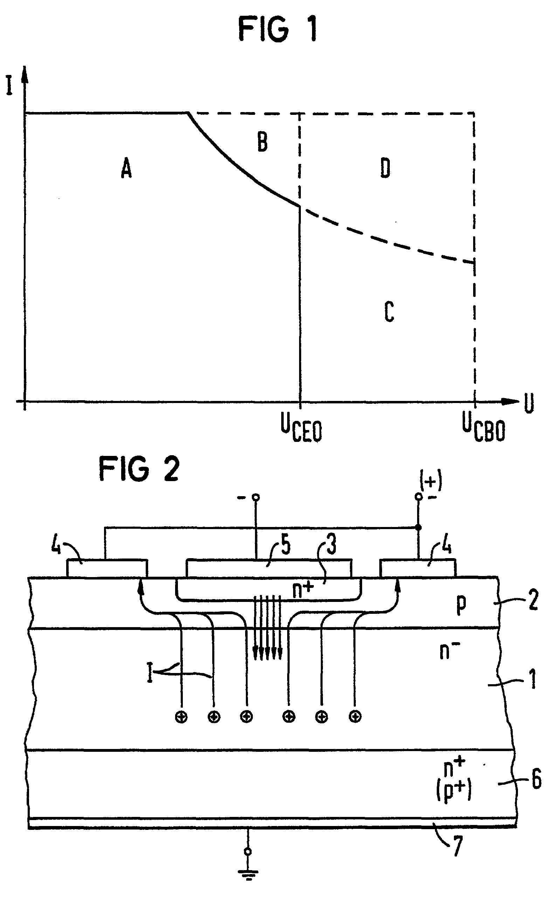

Der sichere Arbeitsbereich eines Leistungs-Halbleiterschalters für das Abschalten, d. h., bei in Sperrichtung vorgespanntem Emitter-Basis-pn-Übergang, RBSOA (Reverse Biased SOA) genannt, ist in Fig. 1 schematisch dargestellt. Er ist für einen herkömmlichen Halbleiter-Leistungsschalter im Gleichstrombetrieb mit dem Buchstaben A bezeichnet und darf für den Impulsbetrieb in den Bereich B ausgedehnt werden. Für beide Fälle ist die maximale Betriebsspannung die Spannung $U_{CEO}$, d. h. die maximale Emitter-Kollektorspannung mit offenem Basisanschluß. Diese Spannung darf nicht überschritten werden, wenn der Schalter nicht durch "second break down" zerstört werden soll.

In Fig. 2 ist dieser Vorgang veranschaulicht. Dort ist ein Leistungs-Halbleiterschalter mit einem Halbleiterkörper dargestellt. Er hat eine erste Zone 1, die z. B. n-dotiert ist. An die Zone 1 grenzt eine zweite Zone 2 vom entgegengesetzten Leitungstyp mit höherer Dotierung als die Zone 1. An die zweite Zone 2 grenzt eine dritte Zone 3 vom ersten Leitungstyp mit höherer Dotierung als die zweite Zone 2. An die von der zweiten Zone 2 abgewandten Seite der ersten Zone 1 grenzt eine vierte Zone 6, die für einen Schalttransistor n-dotiert ist und höhere Dotierung als die Zone 1 hat. Für einen GTO-Thyristor ist diese Zone p-dotiert und hat höhere Dotierungskonzentration als die Zone 1.

Im eingeschalteten Zustand des Schalters liege an der Emitterelektrode 5 negatives Potential, an der Anodenelektrode 7 Nullpotential und an der Gateelektrode 4 positives Potential. Dann ist die Zone 1 von Ladungsträgern überschwemmt und der Schalter leitet. Zum Sperren wird die Gateelektrode 4 negativ gegen die Emitterelektrode 5 vorgespannt. Dann fließen die hauptsächlich in der Zone 1 gespeicherten Ladungsträger zur Elektrode 4 bzw. 7 ab. In der Figur ist der Weg der positiven Ladungsträger zur Elektrode 4 mit Pfeilen I gekennzeichnet. Sie nehmen den durch die Richtung der Feldstärke vorgegebenen Weg in Richtung zur Emitterzone 3 und fließen dann radial nach außen zu den Elektroden 4 ab. Dabei wird eine Emittervorspannung erzeugt, die in der Mitte des Emitters 3 am höchsten ist. Übersteigt sie hier ungefähr 0,7 V, beginnt der Emitter an dieser Stelle zu emittieren. Dieser Vorgang kann sich durch Trägervervielfachung noch verstärken, bis der Schalter durch lokale Überhitzung zerstört wird. Diese Vorgänge werden "second break down" genannt. Daher darf ein Schalttransistor herkömmlicher Art nur bis zu derjenigen Spannung betrieben werden, bei der die Trägervervielfachung noch nicht einsetzt. Diese Spannung ist die in FIG 1 eingezeichnete Spannung $U_{CEO}$.

Die Erfindung bezieht sich auf einen Halbleiter-Leistungsschalter mit einem Halbleiterkörper mit den Merkmalen:

a) Der Halbleiterkörper hat eine erste Zone vom ersten Leitungstyp und einer gegebenen Dotierungshöhe,

b) an die erste Zone und an die erste Oberfläche des Halbleiterkörpers grenzt eine zweite Zone vom zweiten Leitungstyp, die eine höhere Dotierung als die erste Zone hat,

c) an die zweite Zone und an die erste Oberfläche des Halbleiterkörpers grenzt eine Vielzahl von Emitterzonen vom ersten Leitungstyp und höherer Dotierung als die zweite Zone

d) an die erste Zone und an die zweite Zone mit höherer Dotierung als die erste Zone,

e) die Emitterzonen sind einander elektrisch parallel geschaltet.

Solche Halbleiter-Leistungsschalter sind beispielsweise in den europäischen Patenten 110 777 und 1 28 268 beschrieben worden.

Der Erfindung liegt die Aufgabe zugrunde, einen Halbleiter-Leistungsschalter dieser Art derart weiterzubilden, daß er mit einer Spannung betrieben werden kann, die größer als die Spannung $U_{CEO}$ ist.

Diese Aufgabe wird gelöst durch die Merkmales:

f) die Breite der Emitterzonen liegt unter 30 μm,

g) der Abstand der Emitterzonen ist kleiner als die Dicke

Diese Merkmale sind aus den obengenannten Dokumenten nicht bekannt. Hinweise auf die der Erfindung zugrundeliegende Aufgabe sind diesen Dokumenten ebenfalls nicht zu entnehmen.

Gemäß einer Alternative kann die Aufgabe auch durch folgende Merkmale gelöst werden:

e) Die Emitterzone ist netzförmig ausgebildet,

f) innerhalb der Emitterzone tritt die zweite Zone in voneinander getrennten Bereichen an die erste Oberfläche des Halbleiterkörpers,

g) der Abstand der Bereiche voneinander liegt unter 30 μm,

h) die lateralen Abmessungen der Bereiche sind kleiner als die Dicke der ersten Zone.

Weiterbildungen der Erfindung sind Gegenstand der Unteransprüche 2 bis 6 und 8 bis 12.

Die Erfindung wird anhand einiger Ausührungsbeispiele in Verbindung mit den FIG 3 bis 7 näher erläutert. Es zeigen:

FIG 3 einen Schnitt durch einen Leistungs-Halbleiterschalter mit seinen charakteristischen Größenabmessungen,

FIG 4 die Aufsicht auf einen Halbleiterkörper mit mehreren kleinflächigen Emitterzonen,

FIG 5 die Ausicht auf ein zweites Ausführungsbeispiel mit mehreren streifenförmigen Emitterzonen,

Fig. 6 die Aufsicht auf ein weiteres Ausführungsbeispiel mit mehreren ringförmigen Emitterzonen und

Fig. 7 die Aufsicht auf ein anderes Ausführungsbeispiel, bei dem der Emitter als Netz (Mesh-Struktur) ausgebildet ist.

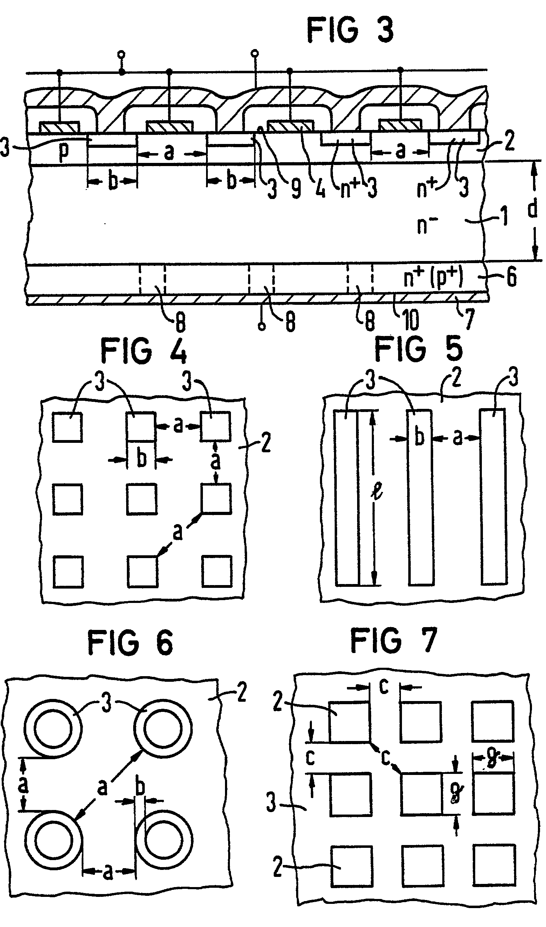

Der Halbleiter-Leistungsschalter nach Fig. 3 kann ein Schalttransistor oder ein GTO-Thyristor sein. Beim Schalttransistor ist die Zonenfolge von oben nach unten $n^+pn^-n^+$ und beim GTO-Thyristor $n^+pn^-p^+$. Dabei grenzt die Zone 2 sowohl an die Zone 1 als auch an die Oberfläche 9 des Halbleiterkörpers an. Die Emitterzone 3 kann, wie in Fig. 4 dargestellt, durch eine Vielzahl von elektrisch einander parallelgeschalteten Emitterzellen 3 gebildet werden, die jeweils eine in sich geschlossene Fläche bilden. Diese Emitterzellen können quadratisch, rechteckig, kreisrund oder als Polygon ausgebildet sein. Sie grenzen einerseits an die zweite Zone 2 und anderseits an die erste Oberfläche 9 des Halbleiterkörpers. Der Abstand der Emitterzellen voneinander ist mit a bezeichnet, die Breite der Emitterzellen mit b, die Dicke der ersten Zone 1 mit d. Wesentlich ist, daß die Breite b der Emitterzellen 3 kleiner als 30 μm ist und daß der größte Abstand a der Emitterzonen voneinander kleiner als die Dicke d der ersten Zone 1 ist. Dabei muß der Abstand a der Emitterzellen 3 diese Bedingung in jeder Richtung der Oberfläche des Halbleiterkörpers erfüllen, d. h. sowohl in der x- als auch in der y-Richtung als auch in der Diagonalen, wie in Fig. 4 dargestellt ist.

Bezüglich der Breite der Emitterzellen b gilt, daß diese lediglich in einer Richtung nicht überschritten werden darf. In der Längsausdehnung können die Emitterzellen 3 daher beispielsweise streifenförmig ausgebildet sein mit einer Länge l≫b. Dies ist in Fig. 5 dargestellt. Auch diese Emitterzonen sind elektrisch parallelgeschaltet.

Die Emitterzellen können auch ringförmig ausgebildet sein, wie in Fig. 6 gezeigt. Dabei ist der Abstand der Emitterzellen 3 ebenfalls mit a bezeichnet und unterliegt den oben erwähnten Bedingungen, daß er kleiner als die Dicke d der ersten Zone 1 liegen muß. Die Breite b ist hier die Breite des Ringes, nicht etwa der Außendurchmesser der gesamten Zelle. Das Innere des Ringes, in dem die Basiszone an die Oberfläche 9 des Halbleiterkörpers tritt, kann kontaktiert sein.

In Fig. 7 ist ein Schalter mit netzförmiger Struktur des Emitters 3 dargestellt. Hier ist lediglich eine einzige zusammenhängende Emitterzone vorgesehen, innerhalb der sich die Basiszone 2 in einzelnen Bereichen zur Oberfläche 9 des Halbleiterkörpers erstreckt. Hier gilt als Alternative zu den in Verbindung mit den Fig. 4, 5 und 6 erläuterten Ausführungsbeispielen, daß die Breite der Emitterzone durch den Abstand c der Basiszonenbereiche gegeben ist. Der größte Abstand c liegt ebenfalls unter 30 μm, während die lateralen Abmessungen g der Basiszonenbereiche kleiner als die Dicke d der ersten Zone 1 sind. Vorzugsweise liegen sie zwischen dem 0,1- und 0,7fachen.

Als bevorzugte Breite b bzw. c kommt ein Bereich von 1 bis 10 μm in Frage. Dabei sollten die Emitter so schmal wie möglich gemacht werden. Die untere Grenze der Breite ist dabei einmal durch die Art der Herstellungsverfahren des Halbleiterkörpers und zum anderen durch die Art der Kontaktierung der Emitterzonen gegeben. Die Gesamtfläche des Emitters sollte hierbei einen bestimmten Wert nicht unterschreiten, so daß die kritische Emitterstromdichte von $10^4$ bis $10^5$ A/cm² nicht überschritten wird. Die untere Grenze für den Abstand a bzw. g ist durch die Art der Kontaktierung der Basiszone gegeben. Die obere Grenze für den Abstand a = d sollte nicht überschritten werden, da sonst die Ausnutzung der Fläche des Halbleiterkörpers verschlechtert und die Stromtragfähigkeit verringert würde.

Versuche mit Schaltern mit einer Emitterzonenbreite von 2, 5, 10, 20 μm, einem Abstand a = 40 μm, einer Dicke d = 100 μm und einer Dotierung der ersten Zone 1 von $10^{14}$ Atomen/cm³ haben gezeigt, daß ein solcher Schalter im Gleichstromfall bis in den durch C gekennzeichneten Bereich der Fig. 1 belastet werden kann, im Impulsfall sogar bis in den Bereich D. Dies wird verständlich, da die geringe Breite der Emitterzone 3 zusammen mit den übrigen Parametern des Schalters sogar im Kurzschlußfall unter den Emitterzonen keine Spannung hervorrufen können, die größer als 0,7 V ist. Damit arbeitet der Schalttransistor beim Abschalten praktisch als Diode mit den Zonen 2, 1 und 6.

Mit der Erfindung ist es daher möglich, einen Halbleiter-Leistungsschalter mit einer höheren Betriebsspannung als $U_{CEO}$ zu beaufschlagen. Dabei wurde trotz gegenüber dem Stand der Technik drastisch verringerter Emitterfläche keine Verminderung der Stromtragfähigkeit beobachtet. Dies ist damit zu erklären, daß sich die stromführenden Bereiche in der Zone 1 ausgehend von der Emitterseite zur Katodenseite unter einem Winkel von etwa 45° verbreitern. Damit ist aber entgegen bisheriger Meinung fast ausschließlich die Fläche des Halbleiterkörpers für die Stromtragfähigkeit maßgebend und nicht die Emitterfläche.

Um dasselbe Ergebnis bei einem GTO-Thyristor zu erhalten, wird die zwischen Zone 1 und zweiter Oberfläche 10 des Halbleiterkörpers liegende Zone 6 in üblicher Weise mit Nebenschlüssen 8 versehen, durch die die erste Zone 1 bis zur Elektrode 7 durchgreift. Damit wird die Zone 6 in bestimmten Bereichen mit der Zone 1 stark kurzgeschlossen und damit im Abschaltfall unwirksam.

## Patentansprüche

1. Halbleiter-Leistungsschalter mit einem Halbleiterkörper mit den Merkmalen:
a) Der Halbleiterkörper hat eine erste Zone (1) vom ersten Leitungstyp und einer gegebenen Dotierungshöhe,
b) an die erste Zone (1) und an die erste Oberfläche (9) des Halbleiterkörpers grenzt eine zweite Zone (2) vom zweiten Leitungstyp, die eine höhere Dotierung als die erste Zone (1) hat,
c) an die zweite Zone (2) und an die erste Oberfläche (9) des Halbleiterkörpers grenzt eine Vielzahl von Emitterzonen (3) vom ersten Leitungstyp und höherer Dotierung als die zweite Zone (2),
d) an die erste Zone (1) und an die zweite Oberfläche (10) des Halbleiterkörpers grenzt eine vierte Zone (6) mit höherer Dotierung als die erste Zone,
e) die Emitterzonen sind einander elektrisch parallel geschaltet, gekennzeichnet durch die Merkmale:
f) die Breite (b) der Emitterzonen (3) liegt unter 30 µm,
g) der Abstand (a) der Emitterzonen (3) ist kleiner als die Dicke d) der ersten Zone.

2. Halbleiter-Leistungsschalter nach Anspruch 1, **dadurch gekennzeichnet**, daß der Abstand (a) der Emitterzonen voneinander zwischen dem 0,1- und dem 0,7fachen der Dicke (d) der ersten Zone (1) liegt.

3. Halbleiter-Leistungsschalter nach Anspruch 1 oder 2, **dadurch gekennzeichnet**, daß die Breite der Emitterzonen (3) zwischen 1 und 10 µm liegt.

4. Halbleiter-Leistungsschalter nach einem der Ansprüche 1 bis 3, **dadurch gekennzeichnet**, daß die Emitterzonen streifenförmig ausgebildet sind.

5. Halbleiter-Leistungsschalter nach einem der Ansprüche 1 bis 3, **dadurch gekennzeichnet**, daß die Emitterzonen ringförmig ausgebildet sind.

6. Halbleiter-Leistungsschalter nach einem der Ansprüche 1 bis 7, daß die Emitterzonen (3) eine geschlossene Fläche bilden.

7. Halbleiter-Leistungsschalter mit einem Halbleiterkörper mit den Merkmalen:
a) Der Halbleiterkörper hat eine erste Zone (1) vom ersten Leitungstyp und einer gegebenen Dotierungshöhe,
b) an die erste Zone (1) und an die erste Oberfläche (9) des Halbleiterkörpers grenzt eine zweite Zone (2) vom zweiten Leitungstyp, die eine höhere Dotierung als die erste Zone (1) hat,
c) an die zweite Zone (2) und an die erste Oberfläche (9) des Halbleiterkörpers grenzt mindestens eine Emitterzone (3) vom ersten Leitungstyp und höherer Dotierung als die zweite Zone (2),
d) an die erste Zone (1) und an die zweite Oberfläche des Halbleiterkörpers grenzt eine vierte Zone (6) mit höherer Dotierung als die erste Zone,
f) innerhalb der Emitterzone (3) tritt die zweite Zone (2) in voneinander getrennten Bereichen an die erste Oberfläche (9) des Halbleiterkörpers,
g) der Abstand (c) der Bereiche voneinander liegt unter 30 µm,
h) die lateralen Abmessungen (g) der Bereiche der zweiten Zone (2) sind kleiner als die Dicke (d) der ersten Zone (1).

8. Halbleiter-Leistungsschalter nach Anspruch 7, **dadurch gekennzeichnet**, daß die lateralen Abmessungen (9) der Bereiche zwischen dem 0,1- und dem 0,7fachen der Dicke (d) der ersten Zone (1) liegen.

9. Halbeiter-Leistungsschalter nach Anspruch 7 oder 8, **dadurch gekennzeichnet**, daß der Abstand (c) der Bereiche zwischen 1 und 10 µm liegt.

10. Halbleiter-Leistungsschalter nach einem der Ansprüche 1 bis 9, **dadurch gekennzeichnet**, daß die Gesamtfläche der Emitterzonen (3) mindestens so groß ist, daß eine Stromdichte von $10^4$ bis $10^5$ A/cm² nicht überschritten wird.

11. Halterbleiter-Leistungsschalter nach einem der Ansprüche 1 bis 10, **dadurch gekennzeichnet**, daß die vierte Zone (6) vom ersten Leitungstyp ist.

12. Halbleiter-Leistungsschalter nach einem der Ansprüche 1 bis 10, **dadurch gekennzeichnet**, daß die vierte Zone (6) vom zweiten Leitungstyp ist.

## Revendications

1. Interrupteur de puissance à semi-conducteurs comprenant un corps semi-conducteur ayant les particularités:
a) le corps semi-conducteur présente une première zone (1) d'un premier type de conductivité et d'un niveau de dopage donné,
b) une deuxième zone (2) d'un second type de conductivité, possédant un dopage plus fort que la première zone (1), est adjacente à la première zone (1) et à une première surface (9) du corps semi-conducteur,
c) un grand nombre de zones d'émetteur (3) du premier type de conductivité et de dopage plus fort que la deuxième zone (2), est adjacent à la deuxième zone (2) et à la première surface (9) du corps semi-conducteur,
d) une quatrième zone (6) de plus fort dopage que la première zone (1) est adjacente à la première zone et à la seconde surface (10) du corps semi-conducteur,
e) les zones d'émetteur sont connectées électriquement en parallèle entre elles, caractérisé en ce que:
f) la largeur (b) des zones d'émetteur (3) est inférieure à 30 µm,
g) l'espacement (a) des zones d'émetteur (3) est plus petit que l'épaisseur (d) de la première zone.

2. Interrupteur selon la revendication 1, caractérisé en ce que l'espacement (a) des zones d'émetteur entre elles est compris entre 0,1 et 0,7 fois l'épaisseur (d) de la première zone (1).

3. Interrupteur selon la revendication 1 ou 2, caractérisé en ce que la largeur des zones d'émetteur (3) est comprise entre 1 et 10 µm.

4. Interrupteur selon une des revendications 1 à 3, caractérisé en ce que les zones d'émetteur sont réalisées sous forme de bandes.

5. Interrupteur selon une des revendications 1 à 3, caractérisé en ce que les zones d'émetteur sont réalisées sous forme d'anneaux.

6. Interrupteur selon une des revendications 1 à 5, caractérisé en ce que les zones d'émetteur (3) forment une aire de surface fermée en elle-même.

7. Interrupteur de puissance à semi-conducteur, comprenant un corps semi-conducteur ayant les particularités:

a) le corps semi-conducteur présente une première zone (1) d'un premier type de conductivité et d'un niveau de dopage donné,

b) une deuxième zone (2) d'un second type de conductivité, possédant un dopage plus fort que la première zone (1), est adjacente à la première zone (1) et à une première surface (9) du corps semi-conducteur,

c) au moins une zone d'émetteur (3), du premier type de conductivité et de plus fort dopage que la deuxième zone (2), est adjacente à la deuxième zone (2) et à la première surface (9) du corps semi-conducteur,

d) une quatrième zone (6) de plus fort dopage que la première zone (1) est adjacente à la première zone (1) et à la seconde surface du corps semi-conducteur, caractérisé en ce que:

e) la zone d'émetteur (3) est réalisée sous la forme d'un réseau,

f) à l'intérieur de la zone d'émetteur (3), la deuxième zone (2) s'étend jusqu'a la première surface (9) du corps semiconducteur par des régions mutuellement séparées,

g) l'espacement (c) des régions entre elles est inférieur à 30 μm,

h) les dimensions latérales (g) des régions de la deuxième zone (2) sont plus petites que l'épaisseur (d) de la première zone (1).

8. Interrupteur selon la revendication 7, caractérisé en ce que les dimensions latérales (9) des régions sont comprises entre 0,1 et 0,7 fois l'épaisseur (d) de la première zone (1).

9. Interrupteur selon la revendication 7 ou 8, caractérisé en ce que l'espacement (c) des régions est compris entre 1 et 10 μm.

10. Interrupteur selon une des revendications 1 à 9, caractérisé en ce que l'aire de surface totale des zones d'émetteur (3) est au moins suffisamment grande pour qu'une densité de courant de $10^4$ à $10^5$ A/cm$^2$ ne soit pas dépassée.

11. Interrupteur selon une des revendications 1 à 10, caractérisé en ce que la quatrième zone (6) est du premier type de conductivité.

12. Interrupteur selon une des revendications 1 à 10, caractérisé en ce que la quatrième zone (6) est du deuxième type de conductivité.

**Claims**

1. Semiconductor power switch having a semiconductor body with the following features:

a) The semiconductor body has a first zone (1) of the first conduction type and a given doping level,

b) adjacent to the first zone (1) and to the first surface (9) of the semiconductor body is a second zone (2) of the second conduction type which is more heavily doped than the first zone (1),

c) adjacent to the second zone (2) and to the first surface (9) of the semiconductor body is a multiplicity of emitter zones (3) of the first conduction type and more heavily doped than the second zone (2),

d) adjacent to the first zone (1) and to the second surface (10) of the semiconductor body is a fourth zone (6) with heavier doping than the first zone, e) the emitter zones are connected in parallel with each other electrically, characterized by the following features:

f) the width (b) of the emitter zones (3) is less than 30 μm,

g) the spacing (a) of the emitter zones (3) is less than the thickness (d) of the first zone.

2. Semiconductor power switch according to Claim 1, characterized in that the spacing (a) of the emitter zones from each other is between 0.1 and 0.7 times the thickness (d) of the first zone (1).

3. Semiconductor power switch according to Claim 1 or 2, characterized in that the width of the emitter zones (3) is between 1 and 10 μm.

4. Semiconductor power switch according to one of Claims 1 to 3, characterized in that the emitter zones are of strip-type construction.

5. Semiconductor power switch according to one of Claims 1 to 3, characterized in that the emitter zones are of annular construction.

6. Semiconductor power switch according to one of Claims 1 to 7, characterized in that the emitter zones (3) form a closed area.

7. Semiconductor power switch having a semiconductor body, with the following features:

a) The semiconductor body has a first zone (1) of the first conduction type and a given doping level,

b) adjacent to the first zone (1) and to the first surface (9) of the semiconductor body is a second zone (2) of the second conduction type which is more heavily doped than the first zone (1),

c) adjacent to the second zone (2) and to the first surface (9) of the semiconductor body is at least one emitter zone (3) of the first conduction type and more heavily doped than the second zone (2),

d) adjacent to the first zone (1) and to the second surface of the semiconductor body is a fourth zone (6) with heavier doping than the first zone, characterized by the following features:

e) the emitter zone (3) is of reticular construction,

f) within the emitter zone (3), the second zone (2) emerges at the first surface (9) of the semiconductor body in regions separated from each other,

g) the spacing (c) of the regions from each other is less than 30 μm,

h) the lateral dimensions (g) of the regions of the second zone (2) are less than the thickness (d) of the first zone (1).

8. Semiconductor power switch according to Claim 7, characterized in that the lateral dimensions (9) of the regions is between 0.1 and 0.7 times the thickness (d) of the first zone (1).

9. Semiconductor power switch according to Claim 7 or 8, characterized in that the spacing (c) of the regions is between 1 and 10 μm.

10. Semiconductor power switch according to one of Claims 1 to 9, characterized in that the total area of the emitter zones (3) is at least so large that a

current density of $10^4$ to $10^5$ A/cm$^2$ is not exceeded.

11. Semiconductor power switch according to one of Claims 1 to 10, characterized in that the fourth zone (6) is of the first conduction type.

12. Semiconductor power switch according to one of Claims 1 to 10, characterized in that the fourth zone (6) is of the second conduction type.

# FIG 1

# FIG 2

# FIG 3

# FIG 4

# FIG 5

# FIG 6

# FIG 7